# FASCICULE DE BREVET EUROPEEN

(11) **EP 1 354 346 B1**
(45) Date de publication et mention de la délivrance du brevet: **02.05.2012**
(21) Numéro de dépôt: 01999973.9
(22) Date de dépôt: 07.12.2001
(51) Int. Cl.: H01L 21/762

(54) **PROCEDE DE REALISATION D'UNE COUCHE MINCE IMPLIQUANT L'IMPLANTATION D'ESPECES GAZEUSES**
VERFAHREN ZUR HERSTELLUNG EINES DÜNNFILMS DURCH IMPLANTATION VON GASFÖRMIGEN TEILCHEN
METHOD FOR PRODUCING A THIN FILM COMPRISING IMPLANTATION OF GASEOUS SPECIES

(30) Priorité: 08.12.2000 FR 0015980
(43) Date de publication de la demande: 22.10.2003
(73) Titulaire: Commissariat à l'Énergie Atomique et aux Énergies Alternatives, 75015 Paris (FR)
(72) Inventeur: ASPAR, Bernard, F-38140 Rives (FR); BRUEL, Michel, F-38113 Veurey-Voroize (FR)
(74) Mandataire: Poulin, Gérard
(86) Numéro de dépôt international: PCT/FR2001/003873
(87) Numéro de publication internationale: WO 2002/047156

(56) Documents cités:
- EP-A- 0 665 588
- EP-A- 0 763 849
- EP-A- 0 767 486
- PATENT ABSTRACTS OF JAPAN vol. 1999, no. 10, 31 août 1999 (1999-08-31) & JP 11 126910 A (DENSO CORP), 11 mai 1999 (1999-05-11) -& US 6 191 007 B1 (OHSHIMA HISAYOSHI ET AL) 20 février 2001 (2001-02-20)
- PATENT ABSTRACTS OF JAPAN vol. 1999, no. 02, 26 février 1999 (1999-02-26) -& JP 10 308355 A (DENSO CORP), 17 novembre 1998 (1998-11-17)
- "SOI INTERPOSER STRUCTURE" IBM TECHNICAL DISCLOSURE BULLETIN, IBM CORP. NEW YORK, US, vol. 39, no. 7, 1 juillet 1996 (1996-07-01), pages 191-195, XP000627972 ISSN: 0018-8689

## Description

### Domaine technique

La présente invention concerne un procédé de réalisation d'une couche mince impliquant l'introduction d'espèces gazeuses. Elle permet en particulier de réaliser des couches d'épaisseur relativement fortes. Elle trouve des applications notamment dans le domaine des semi-conducteurs.

### Etat de la technique antérieure

L'introduction d'espèces gazeuses dans un matériau solide peut être avantageusement réalisée par implantation ionique. Ainsi, le document FR-A-2 681 472 (correspondant au brevet américain N° 5 374 564) décrit un procédé de fabrication de films minces de matériau semiconducteur. Ce document divulgue que l'implantation d'un gaz rare et/ou d'hydrogène dans un substrat en matériau semiconducteur est susceptible d'induire, dans certaines conditions, la formation de microcavités ou de microbulles (encore désignées par le terme "platelets" dans la terminologie anglo-saxonne) à une profondeur voisine de la profondeur moyenne de pénétration des ions implantés. Si ce substrat est mis en contact intime, par sa face implantée avec un raidisseur et qu'un traitement thermique est appliqué à une température suffisante, il se produit une interaction entre les microcavités ou les microbulles conduisant à une séparation du substrat semiconducteur en deux parties : un film mince semiconducteur adhérant au raidisseur d'une part, le reste du substrat semiconducteur d'autre part. La séparation a lieu au niveau de la zone où les microcavités ou microbulles sont présentes. Le traitement thermique est tel que l'interaction entre les microbulles ou microcavités créées par implantation est apte à induire une séparation entre le film mince et le reste du substrat. On peut donc obtenir le transfert d'un film mince depuis un substrat initial jusqu'à un raidisseur servant de support à ce film mince.

La création d'une zone fragilisée et la séparation au niveau de cette zone peuvent également être utilisées pour la fabrication d'un film mince de matériau solide autre qu'un matériau semiconducteur, un matériau conducteur ou diélectrique, cristallin ou non (voir le document FR-A-2 748 850).

Ce procédé s'avère très intéressant et est utilisé notamment pour obtenir des substrats SOI. Le passage de ces ions peut amener des perturbations pour certaines applications. Cependant, l'épaisseur de film mince obtenu dépend de l'énergie d'implantation que peut fournir les implanteurs. L'obtention de films relativement épais (50 µm par exemple) exige des implanteurs très puissants, ce qui impose une limite pour les épaisseurs disponibles. Il peut en outre présenter un inconvénient en ce sens que le film mince obtenu a été traversé par les ions destinés à former les microcavités.

Le document FR-A-2 738 671 (correspondant au brevet américain N° 5 714 395) divulgue un procédé utilisant également l'implantation ionique pour créer une zone fragilisée qui permet, grâce à un traitement postérieur, d'obtenir la séparation d'une couche superficielle d'avec le reste d'un substrat initial. Selon ce document, l'implantation ionique est effectuée à une profondeur supérieure ou égale à une profondeur minimum déterminée pour que le film mince obtenu soit rigide après sa séparation d'avec le reste du substrat initial. On entend par film rigide un film autoporté, c'est-à-dire indépendant mécaniquement et pouvant être utilisé ou manipulé directement. Les documents Patent Abstracts of Japan, vol. 1999, N°10, 31 août 1999, JP-A-11 126 910 et US 6 191 007 divulguent un procédé de réalisation d'une couche mince à partir d'une structure, le procédé impliquant l'introduction d'espèces gazeuses pour créer une zone fragilisée conduisant à une spération de la structure au niveau de cette zone fragilisée. Ce procédé comprend les étapes suivantes :
a) réalisation d'une structure empilée formée d'une première partie conçue pour faciliter l'introduction des espèces gazeuses et d'une deuxième partie, la deuxième partie possédant une première face libre et une deuxième face solidaire de la première partie,
b) introduction d'espèces gazeuses dans la structure, à partir de la première partie pour créer une zone fragilisée, la couche mince étant ainsi délimitée entre ladite première face libre de la deuxième partie et ladite zone fragilisée,
c) séparation de la couche mince du reste de la structure au niveau de la zone fragilisée.

### Exposé de l'invention

Pour remédier à ces inconvénients, la présente invention propose d'implanter (ou d'introduire) les espèces gazeuses par la face arrière du substrat, c'est-à-dire par la face du substrat opposée au film ou couche mince désirée. Pour cela, il faut que le substrat soit "transparent aux ions" du côté de sa face arrière.

L'invention a donc pour objet un procédé de réalisation d'une couche mince à partir d'une structure selon la revendication 1.

L'implantation d'espèces gazeuses est réalisée par implantation ionique au travers de la face libre de la première partie.

L'implantation d'espèces gazeuses peut créer une zone fragilisée dans la première partie, dans la deuxième partie ou à l'interface entre la première partie et la deuxième partie.

La première partie comprend un support transparent aux espèces gazeuses implantées, c'est-à-dire un support présentant des ouvertures aux espèces gazeuses implantées, le rapport de la surface totale des ouvertures par rapport à la surface du support étant tel que la séparation peut se produire au niveau de la zone fragilisée créée. Le support peut être une grille, la première partie comprenant aussi un film déposé sur la grille et solidaire de la deuxième partie.

Avantageusement, la première partie comprend une couche superficielle servant de germe pour la croissance de la deuxième partie sur la première partie. La croissance de la deuxième partie peut être réalisée par un procédé de dépôt CVD ou un procédé d'épitaxie en phase liquide. L'introduction d'espèces gazeuses peut être menée de façon que la zone fragilisée laisse subsister, après séparation, en surface de la première partie une couche pouvant servir de germe pour faire croître à nouveau une deuxième partie sur la première partie.

Eventuellement, avant l'étape b) ou avant l'étape c), un support intermédiaire est fixé sur la première partie. Après l'étape : c), le support intermédiaire peut être éliminé.

La structure peut comprendre une couche destinée à favoriser la séparation, les espèces gazeuses étant implantées dans cette couche.

L'étape de séparation peut être réalisée par apport d'énergie thermique et/ou mécanique à la zone fragilisée.

L'étape de séparation peut mettre en oeuvre un apport d'énergie pour initier une action de clivage utilisant un front de clivage se propageant le long de la zone fragilisée. Cette technique est en particulier divulguée par le document WO 98/52 216.

Les espèces gazeuses peuvent être choisies parmi l'hydrogène et les gaz rares, ces espèces pouvant être implantées seules ou en combinaison.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1D illustrent un premier mode de réalisation de la présente invention,
- les figures 2A à 2D illustrent un deuxième mode de réalisation de la présente invention.

### Description détaillée de modes de réalisation de l'invention

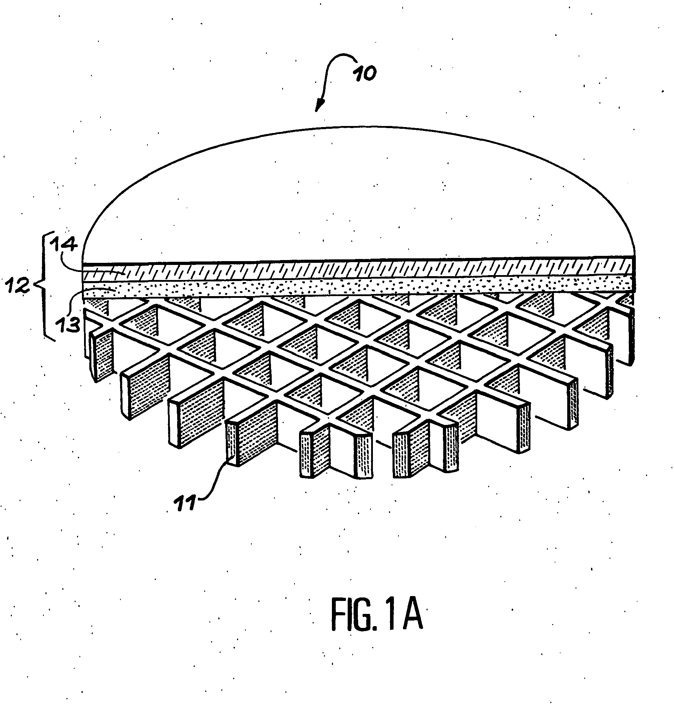

Les figures 1A à 1D illustrent un mode de réalisation de l'invention où la première partie de la structure comprend une grille.
La figure 1A est une vue en perspective et en coupe partielle de cette première partie 10. La première partie 10 comprend une grille 11 formée de barreaux dont la section peut être carrée ou rectangulaire. Les barreaux ont par exemple 80 µm de largeur et peuvent être espacés de quelques centaines de micromètres à quelques millimètres. Suivant les dimensions des barreaux et des espacements qui les séparent, la grille peut servir de raidisseur et permettre la séparation au niveau de la zone implantée sans induire la formation de cloques.

Quand les espacements entre les barreaux sont trop grands et/ou si la profondeur de pénétration des ions n'est pas suffisante pour induire une séparation (on a alors formation de cloques) et conduire à un film autoporté, on peut déposer après l'étape d'implantation une couche qui sert de raidisseur sur la face libre de la première partie.

La grille 11 peut être réalisée par gravure d'une plaquette de Si ou de SiC.

La grille 11 sert de support à un film 12 formé d'une ou plusieurs couches, par exemple de deux couches 13 et 14. Si on désire obtenir à l'issue du procédé une couche mince de silicium monocristallin, la couche 13 peut être en SiO₂ et avoir 1 µm d'épaisseur et la couche 14 peut être en silicium et avoir 2 µm d'épaisseur. Lé film 12 peut être obtenu et déposé sur la grille 11 par le procédé divulgué dans le document FR-A-2 738 671 cité plus haut. Le film 12 peut être rendu solidaire de la grille 11 par une technique d'adhésion moléculaire connue de l'homme de l'art. On peut aussi utiliser une colle pour solidariser le film 12 et la grille 11 en s'assurant que la colle ne perturbe pas l'implantation ionique.

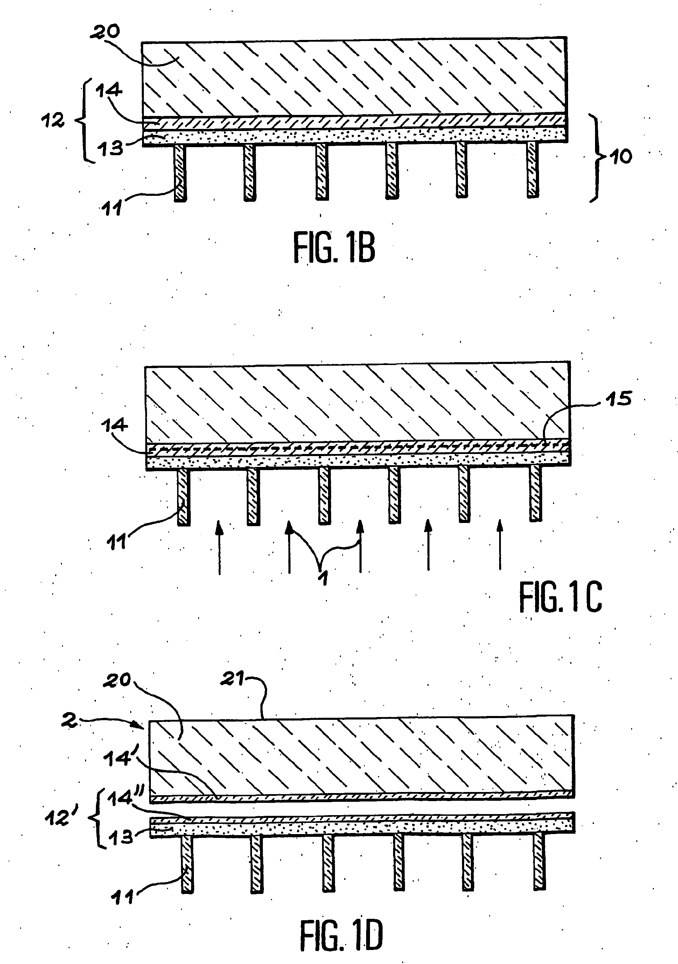

La couche 14 peut alors servir à la formation de la deuxième partie de la structure. C'est ce que montre la figure 1B qui est une vue en coupe transversale de la structure. La deuxième partie 20 est une couche de silicium monocristallin obtenue par croissance à partir de la couche 14 servant de germe. La croissance est par exemple obtenue par une technique de dépôt CVD ou par épitaxie en phase liquide. La deuxième partie 20 peut alors atteindre plusieurs µm, voire quelques dizaines de µm, par exemple 50 µm d'épaisseur.

La figure 1C, qui est également une vue en coupe transversale de la structure, illustre l'étape d'implantation ionique effectuée au travers de la grille 11. L'implantation ionique peut consister à implanter des ions hydrogène, figurés symboliquement par les flèches 1, avec une dose de 10¹⁷H⁺/cm² et une énergie de 400 keV. Les ions parviennent majoritairement dans la couche 14 en silicium pour y former une zone fragilisée 15.

L'introduction d'espèces gazeuses dans une couche de matériau pour constituer,une zone fragilisée peut aussi se faire par d'autres méthodes employées seules ou en combinaison et décrites dans le document FR-A-2 773 261.

La figure 1D, qui est également une vue en coupe transversale de la structure, illustre l'étape de séparation. La séparation peut avoir lieu par recuit thermique et/ou par utilisation de forces mécaniques.

On obtient alors une couche mince 2 entre la face libre 21 de la deuxième partie 20 et l'emplacement initial de la zone fragilisée. La couche initiale 14 est alors scindée en deux sous-couches 14' et 14'". La couche mince 2, d'environ 50 µm d'épaisseur, est récupérée pour être exploitée. Le reste de la structure, constitué de l'empilement grille 11, couche 13 et sous-couche 14" (formant le film 12'), peut être réutilisé comme nouvelle première partie, la sous-couche 14" servant de germe pour la formation d'une nouvelle seconde partie.

Dans cet exemple de réalisation, la zone fragilisée a été créée dans la couche 14 appartenant à la première partie de la structure, la couche mince obtenue comprenant alors la première partie de la structure et une portion de la deuxième partie (la sous-couche 14'). Il entre aussi dans le cadre de la présente invention de créer la zone fragilisée à l'interface des deux parties, auquel cas la couche mince obtenue correspondrait exactement à la deuxième partie de la structure. Cette variante présente un avantage : une zone de défauts créée à cette interface favorise la séparation. Cette zone de défauts peut contenir des défauts cristallins et/ou des microcavités qui vont favoriser la séparation. Il est aussi possible de créer la zone fragilisée dans la deuxième partie de la structure, auquel cas la couche mince obtenue correspondrait à une portion de la deuxième partie.

Dans une variante du procédé, l'introduction des espèces gazeuses peut être réalisée pour une énergie d'implantation de 200 keV par exemple. Dans ce cas, avant séparation on rajoute sur la face libre de la première partie une couche qui sert de raidisseur et qui permet la séparation. Cette couche peut être constituée par exemple de 3 µm d'oxyde de silicium.

La deuxième partie de la structure peut aussi être constituée d'un empilement de couches. Elle peut-être, temporairement ou non, fixée à un support intermédiaire.

Il peut être prévu dans la structure une couche spécifique, par exemple réalisée avant la formation de la deuxième partie, destinée à favoriser la séparation au niveau de la zone fragilisée. La couche spécifique peut être une couche de SiGe épitaxiée sur une couche de silicium de la première partie. La deuxième partie est épitaxiée sur la couche de SiGe et l'implantation est réalisée au niveau de la couche de SiGe contrainte. La couche spécifiée peut être une couche de silicium fortement dopée au bore. Un tel matériau permet d'obtenir une séparation à l'aide d'un budget thermique et/ou mécanique plus faible.

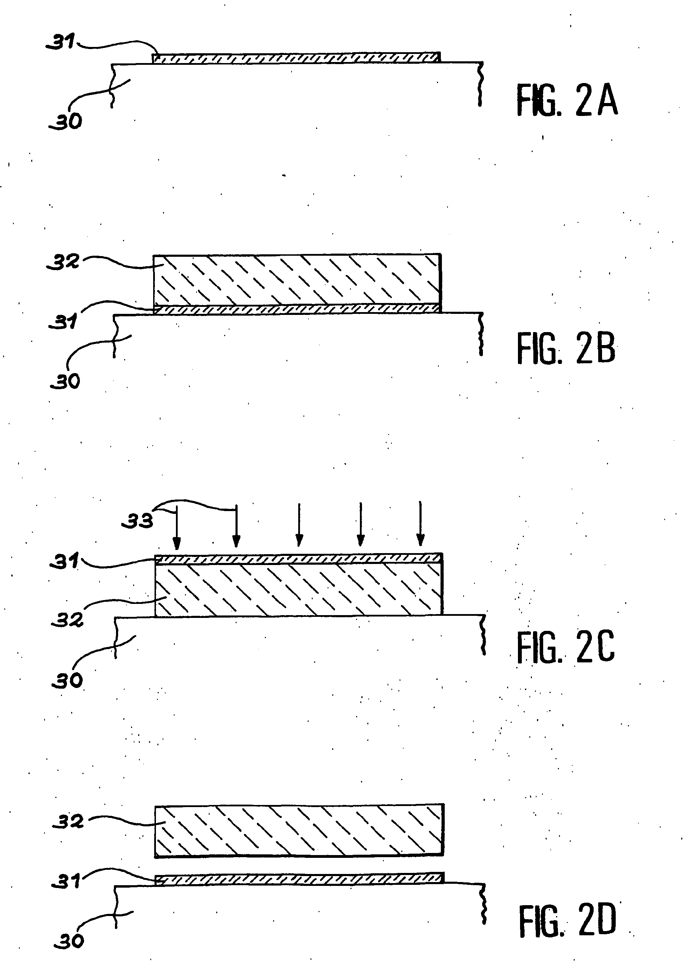

Les figures 2A à 2D illustrent un autre mode de réalisation de l'invention où la première partie de la structure est constituée par un film autoporté. Ces figures sont des vues en coupe transversale.
La figure 2A montre un film autoporté 31 posé sur un support 30 sans y adhérer. Le film autoporté 31 est par exemple un film de silicium de 5 µm d'épaisseur obtenu par le procédé divulgué dans le document FR-A-2 738 671 cité plus haut. Ce film 31 constitue la première partie de la structure.
La figure 2B montre qu'une couche 32 a été formée sur le film 31. La couche 32 peut être une couche de silicium de 45 µm d'épaisseur, épitaxiée sur la couche 31. La couche 32 constitue la deuxième partie de la structure. On obtient une structure manipulable.
La figure 2C montre la structure qui a été retournée sur son support 30 pour subir l'étape d'implantation ionique. Des ions hydrogène (figurés symboliquement par les flèches 33) sont alors implantés, par exemple pour une dose de 10¹⁷H⁺/cm² et avec une énergie de 500 keV. Dans cet exemple de réalisation, la zone fragilisée est créée à l'interface entre les deux parties 31 et 32. Pour créer cette zone fragilisée, on peut utiliser une coimplantation d'hélium et d'hydrogène par exemple.

La structure est à nouveau retournée sur son support et, par exemple par un traitement thermique ou par un traitement thermique partiel suivi d'une application de forces mécaniques, la séparation entre les parties 31 et 32 est obtenue. On obtient une couche mince constituée par la deuxième partie 32 comme le montre la figure 2D. La partie 31 peut à nouveau être utilisée pour appliquer le procédé de l'invention.

L'invention s'applique à l'obtention de couches minces de différents matériaux. Il est ainsi possible d'obtenir des couches de GaN autoportées pour des applications optoélectroniques ou microélectroniques. Dans ce cas, le film autoporté peut être en SiC. Sur ce film, on peut réaliser une couche épaisse de GaN par exemple par épitaxie à 1050°C. De l'hydrogène est ensuite implanté selon une dose de 10¹⁶H⁺/cm² à 250 keV dans le SiC au voisinage de l'interface avec GaN. A l'aide par exemple d'un traitement thermique à 850°C, la séparation est obtenue au niveau de la zone implantée. On obtient un film de GaN autoporté muni d'une couche mince de SiC provenant de la séparation. Le reste du film de SiC qui est toujours autoporté peut être recyclé.

## Revendications

1. Procédé de réalisation d'une couche mince (2) à partir d'une structure, le procédé impliquant l'implantation d'espèces gazeuses pour créer une zone fragilisée conduisant à une séparation de la structure au niveau de cette zone fragilisée, le procédé étant **caractérisé en ce qu'**il comprend les étapes suivantes :
a) réalisation d'une structure empilée formée d'une première partie (10), présentant une première face libre et une deuxième face, et d'une deuxième partie (20), présentant une première face libre et une deuxième face, la deuxième face de la deuxième partie étant solidaire de la deuxième face de la première partie, la première partie comprenant un support (11) transparent à des espèces gazeuses implantées, le support présentant des ouvertures aux espèces gazeuses implantées, le support étant une grille formée de barreaux délimitant lesdites ouvertures, le rapport de la surface totale des ouvertures par rapport à la surface du support étant tel que la séparation se produise au niveau de la zone fragilisée créée,
b) implantation d'espèces gazeuses dans la structure, au travers de la face libre de la première partie (10) pour créer une zone fragilisée (15), la couche mince étant ainsi délimitée entre ladite première face libre de la deuxième partie et ladite zone fragilisée,
c) séparation de la couche mince (2) du reste de la structure au niveau de la zone fragilisée.

2. Procédé selon la revendication 1, **caractérisé en ce que** l'implantation d'espèces gazeuses crée une zone fragilisée (15) dans la première partie (10).

3. Procédé selon la revendication 1, **caractérisé en ce que** l'implantation d'espèces gazeuses crée une zone fragilisée dans la deuxième partie.

4. Procédé selon la revendication 1, **caractérisé en ce que** l'implantation d'espèces gazeuses crée une zone fragilisée à l'interface entre la première partie (31) et la deuxième partie (32).

5. Procédé selon la revendication 1, **caractérisé en ce que** la première partie (10) comprend aussi un film (12) déposé sur la grille et solidaire de la deuxième partie (20).

6. Procédé selon la revendication 1, **caractérisé en ce que** la première partie (10) comprend une couche superficielle (14,14") servant de germe pour la croissance de la deuxième partie sur la première partie.

7. Procédé selon la revendication 6, **caractérisé en ce que** la croissance de la deuxième partie est réalisée par un procédé de dépôt CVD ou un procédé d'épitaxie en phase liquide.

8. Procédé selon l'une des revendications 6 ou 7, **caractérisé en ce que** l'introduction d'espèces gazeuses est menée de façon que la zone fragilisée (15) laisse subsister, après séparation, en surface de la première partie (10) une couche (14") pouvant servir de germe pour faire croître à nouveau une deuxième partie sur la première partie.

9. Procédé selon la revendication 1, **caractérisé en ce que**, avant l'étape b) ou avant l'étape c), un support intermédiaire est fixé sur la première partie.

10. Procédé selon la revendication 9, **caractérisé en ce que**, après l'étape c), le support intermédiaire est éliminé.

11. Procédé selon la revendication 1, **caractérisé en ce que** la structure comprend une couche destinée à favoriser la séparation, les espèces gazeuses étant implantées dans cette couche.

12. Procédé selon la revendication 1, **caractérisé en ce que** l'étape de séparation est réalisée par apport d'énergie thermique et/ou mécanique à la zone fragilisée.

13. Procédé selon la revendication 1, **caractérisé en ce que** l'étape de séparation met en oeuvre un apport d'énergie pour initier une action de clivage utilisant un front de clivage se propageant le long de la zone fragilisée.

14. Procédé selon la revendication 1, **caractérisé en ce que** les espèces gazeuses sont choisies parmi l'hydrogène et les gaz rares, ces espèces étant implantées seules ou en combinaison.

## Claims

1. A method for making a thin layer (2) from a structure, the method involving the implantation of gaseous species to create an embrittled zone leading to a separation of the structure at the level of this embrittled zone, the method being **characterised in that** it includes the following steps:
a) making a stacked structure formed of a first part (10), having a first free face and a second face, and a second part (20), having a first free face and a second face, the second face of the second part being integral with the second face of the first part, the first part comprising a support (11) transparent to implanted gaseous species, the support having openings to the implanted gaseous species, the support being a grid formed of bars delimiting said openings, the ratio between the total surface of the openings and the surface of the support being such that the separation occurs at the level of the created embrittled zone,
b) implanting gaseous species into the structure, through the free face of the first part (10), so as to create an embrittled zone (15), the thin layer being thus delimited between said first free face of the second part and said embrittled zone,
c) separating the thin layer (2) from the remaining of the structure at the level of the embrittled zone.

2. Method according to claim 1, **characterised in that** the implantation of gaseous species creates an embrittled zone (15) in the first part (10).

3. Method according to claim 1, **characterised in that** the implantation of gaseous species creates an embrittled zone in the second part.

4. Method according to claim 1, **characterised in that** the implantation of gaseous species creates an embrittled zone at the interface between the first part (31) and the second part (32).

5. Method according to claim 1, **characterised in that** the first part (10) also including a film (12) deposited on the grid and integral with the second part (20).

6. Method according to claim 1, **characterised in that** the first part (10) includes a surface layer (14, 14") acting as the seed for the growth of the second part on the first part.

7. Method according to claim 6, **characterised in that** the growth of the second part is achieved by a CVD deposit method or a liquid phase epitaxy method.

8. Method according to one of claims 6 or 7, **characterised in that** the introduction of gaseous species is achieved in such a way that the embrittled zone (15) leaves behind, after separation, on the surface of the first part (10), a layer (14") able to act as the seed to grow anew a second part son the first part.

9. Method according to claim 1, **characterised in that** before step b) or before step c), an intermediate support is fixed on the first part.

10. Method according to claim 9, **characterised in that** after step c), the intermediate support is eliminated.

11. Method according to claim 1, **characterised in that** the structure includes a layer intended to favour separation, the gaseous species being implanted into this layer.

12. Method according to claim 1, **characterised in that** the separation step is carried out by supplying thermal and/or mechanical energy to the embrittled zone.

13. Method according to claim 1, **characterised in that** the separation step implements an energy supply to initiate a cleavage action using a cleavage front propagating along the embrittled zone.

14. Method according to claim 1, **characterised in that** the gaseous species are selected from among hydrogen and rare gases, these species being implanted alone or in combination.

## Patentansprüche

1. Verfahren zur Herstellung eines Dünnfilms (2) aus einer Struktur, wobei das Verfahren das Ansiedeln von gasförmigen Teilchen zum Schaffen eines geschwächten Bereichs umfasst, welcher zu einer Trennung der Struktur auf Höhe dieses geschwächten Bereichs führt, wobei das Verfahren **dadurch gekennzeichnet ist, dass** es die folgenden Schritte umfasst:
a) Herstellen einer gestapelten Struktur, gebildet aus einem ersten Teil (10), welcher eine erste freie Fläche und eine zweite Fläche aufweist, und einem zweiten Teil (20), welcher eine erste freie Fläche und eine zweite Fläche aufweist, wobei die zweite Fläche des zweiten Teils mit der zweiten Fläche des ersten Teils verbunden ist, wobei der erste Teil eine Stütze (11) umfasst, die für die angesiedelten gasförmigen Teilchen durchlässig ist, wobei die Stütze den angesiedelten gasförmigen Teilchen Öffnungen bietet, wobei die Stütze ein aus die Öffnungen begrenzenden Stäben gebildetes Gitter ist, wobei das Verhältnis der Gesamtfläche der Öffnungen zur Fläche der Stütze derart ist, dass die Trennung auf Höhe des erzeugten geschwächten Bereichs erfolgt,
b) Ansiedeln von gasförmigen Teilchen in der Struktur durch die freie Seite des ersten Teils (10) zum Erzeugen eines geschwächten Bereichs (15) wobei der Dünnfilm auf diese Weise zwischen der ersten freien Fläche des zweiten Teils und dem geschwächten Bereich begrenzt wird,
c) Trennen des Dünnfilms (2) von dem Rest der Struktur auf Höhe des geschwächten Bereichs.

2. Verfahren nach Anspruch 1, **dadurch gekennzeichnet, dass** das Ansiedeln von gasförmigen Teilchen einen geschwächten Bereich (15) im ersten Teil (10) erzeugt.

3. Verfahren nach Anspruch 1, **dadurch gekennzeichnet, dass** das Ansiedeln von gasförmigen Teilchen einen geschwächten Bereich im zweiten Teil erzeugt.

4. Verfahren nach Anspruch 1, **dadurch gekennzeichnet, dass** das Ansiedeln von gasförmigen Teilchen einen geschwächten Bereich an der Schnittstelle zwischen dem ersten Teil (31) und dem zweiten Teil (32) erzeugt.

5. Verfahren nach Anspruch 1, **dadurch gekennzeichnet, dass** der erste Teil (10) ferner einen Film (12) umfasst, welcher auf dem Gitter angebracht wird und mit dem zweiten Teil (20) verbunden ist.

6. Verfahren nach Anspruch 1, **dadurch gekennzeichnet, dass** der erste Teil (10) eine Oberflächenschicht (14, 14") umfasst, die als Keim für das Entstehen des zweiten Teils auf dem ersten Teil dient.

7. Verfahren nach Anspruch 6, **dadurch gekennzeichnet, dass** das Entstehen des zweiten Teils durch ein Verfahren der chemischen Beschichtung aus der Gasphase (CVD) oder ein Verfahren der Flüssigphasenepitaxie realisiert wird.

8. Verfahren nach einem der Ansprüche 6 oder 7, **dadurch gekennzeichnet, dass** das Einführen von gasförmigen Teilchen derart ausgeführt wird, dass der geschwächte Bereich (15) nach der Trennung auf der Oberfläche des ersten Teils (10) eine Schicht (14") bestehen lässt, welche als Keim für das erneute Entstehen eines zweiten Teils auf dem ersten Teil dienen kann.

9. Verfahren nach Anspruch 1, **dadurch gekennzeichnet, dass** vor Schritt b) oder vor Schritt c) eine Zwischenstütze auf dem ersten Teil befestigt wird.

10. Verfahren nach Anspruch 9, **dadurch gekennzeichnet, dass** nach Schritt c) die Zwischenstütze entfernt wird.

11. Verfahren nach Anspruch 1, **dadurch gekennzeichnet, dass** die Struktur eine Schicht umfasst, welche dazu bestimmt ist, die Trennung zu fördern, wobei die gasförmigen Teilchen in dieser Schicht angesiedelt werden.

12. Verfahren nach Anspruch 1, **dadurch gekennzeichnet, dass** der Trennungsschritt durch Zuführen von thermischer und/oder mechanischer Energie in dem geschwächten Bereich ausgeführt wird.

13. Verfahren nach Anspruch 1, **dadurch gekennzeichnet, dass** der Trennungsschritt eine Zufuhr von Energie beinhaltet, um eine Spaltungsaktion mit einer Spaltungsfront auszulösen, welche sich entlang des geschwächten Bereichs ausbreitet.

14. Verfahren nach Anspruch 1, **dadurch gekennzeichnet, dass** die gasförmigen Teilchen aus Wasserstoff und den seltenen Gasen gewählt werden, wobei diese Teilchen allein oder in Kombination angesiedelt werden.
